# EUROPEAN PATENT SPECIFICATION

(11) **EP 3 006 395 B1**
(45) Date of publication and mention of the grant of the patent: **03.07.2019**
(21) Application number: 13885502.8
(22) Date of filing: 19.12.2013
(51) Int. Cl.: B81B 3/00, G02B 26/08, G02B 26/10

(54) **DRIVE DEVICE**
ANTRIEBSVORRICHTUNG
DISPOSITIF D'ENTRAÎNEMENT

(30) Priority: 30.05.2013 WO PCT/JP2013/065089
(43) Date of publication of application: 13.04.2016
(73) Proprietor: Pioneer Corporation, Tokyo 113-0021 (JP); Pioneer Micro Technology Corporation, Yamanashi 400-0053 (JP)
(72) Inventor: FUJIMOTO, Kenjiro, Kawasaki-shi Kanagawa 212-0031 (JP); TAKAHASHI, Hirokazu, Kawasaki-shi Kanagawa 212-0031 (JP); YAMAMURA, Yuuichi, Kofu-shi Yamanashi 400-0053 (JP); KOARAI, Mitsuru, Kofu-shi Yamanashi 400-0053 (JP); YABE, Tomotaka, Kawasaki-shi Kanagawa 212-0031 (JP); FUKASAWA, Yuji, Kofu-shi Yamanashi 400-0053 (JP)
(74) Representative: Viering, Jentschura & Partner mbB Patent- und Rechtsanwälte
(86) International application number: PCT/JP2013/084142
(87) International publication number: WO 2014/192193

(56) References cited:
- EP-A1- 2 503 681
- EP-A2- 1 918 758
- JP-A- 2006 116 696
- JP-A- 2006 330 065
- JP-A- 2011 100 103
- JP-A- 2012 115 981
- US-A1- 2006 261 680
- US-A1- 2011 063 702
- US-A1- 2011 286 070
- US-A1- 2012 008 185

## Description

### Technical Field

The present invention relates to a driving apparatus, such as, for example, a MEMS scanner, configured to drive a driven object, such as a mirror.

### Background Art

In various technical fields such as, for example, a display, a printing apparatus, precision measurement, precision processing, and information recording-reproduction, research on a micro electro mechanical system (MEMS) device manufactured by a semiconductor fabrication technology is actively progressing. As the MEMS device as described above, a mirror driving apparatus having a microscopic structure (or a light scanner or a MEMS scanner) attracts attention, for example, in a display field in which images are displayed by scanning a predetermined screen area by using laser entered from a light source, or in a scanning field in which image information is read by scanning a predetermined screen area by using light and by receiving reflected light.

In the mirror driving apparatus, it is general that a coil and a magnet are used to drive a mirror. In this case, due to an interaction between a magnetic field generated by applying current to the coil and a magnetic field of the magnet, a force in a rotational direction is applied to the mirror. As a result, the mirror is rotated (refer to, for example, Patent Literatures 1 to 3).

### Citation List

### Patent Literature

Patent Literature 1: Japanese Patent Application Laid Open No. 2008-203497
Patent Literature 2: U.S. Patent Application Publication No. 2011/0199172 Specification
Patent Literature 3: Japanese Patent Application Laid Open No. 2011-180322

EP 2 503 681 A1 discloses that a driving apparatus comprises a base part; a driven part capable of rotating; an elastic part which connects the base part and the driven part and which has elasticity for rotating the driven part around an axis along one direction; and an applying part for applying, to the base part, microvibration for rotating the driven part such that the driven part rotates while resonating around the axis along the one direction, at a resonance frequency determined by the elastic part and the driven part (cf. Abstract, claim 1).

EP 1 918 758 A2 discloses that an electromagnetic micro-actuator includes a stage rotatably formed on a surface of a substrate; a pair of torsion springs connected to both sides of the stage in a rotation axis direction; a fixed frame that supports the pair of torsion springs and surrounds the stage; a driving coil wound to a predetermined depth in an upper surface of the stage; a mirror unit formed on a side of the driving coil that is in the stage; and a pair of permanent magnets formed on both sides of the fixed frame facing each other (cf. Abstract).

US 2012/008185 A1 discloses an optical scanning device, having: a substrate main body; two cantilever beams protruded from the respective side portion of one side of the main body; a mirror supported by torsion bars from the respective side, between the beams; a drive source to causes the main body to vibrate; and a light source to project light onto the mirror, wherein a fixed end of the main body is fixed to a supporting member, on the opposite side from the mirror side, wherein the drive source is provided on a part of the main body, and wherein the mirror resonantly vibrates according to vibration applied to the substrate by the drive source, thereby to change a direction of reflection light of the light projected onto the mirror according to the vibration of the mirror, characterized in that a plurality of holes are provided in the main body and the beams (cf. Abstract).

US 2011/286070 A1 discloses that a mirror swing range control device comprises: a swing range detecting section for detecting a swing range of the mirror section swung by driving the vibration source; a signal processing section for arithmetically processing a detection signal, which is generated by the swing range detecting section, so as to generate an inverted detection signal; a standard value generating section for generating a standard value signal indicating a standard time interval; a comparing section for adding the inverted detection signal to the standard value signal, integrating calculated errors and generating an error signal; and a swing range adjusting section for performing feedback control, in which a cancelling signal is applied to the drive circuit for a prescribed time when the comparing section generates the error signal, so as to cancel an increase-decrease value of the error signal (cf. Abstract).

US 2011/063702 A1 discloses that an optical scanner includes: a movable portion having a mirror portion, and a first driving portion which is configured to oscillate the mirror portion around a first axis; a second driving portion which is configured to oscillate the movable portion around a second axis perpendicular to the first axis; and a driving controller which is configured to drive the first driving portion in a first driving method and is configured to drive the second driving portion in a second driving method different from the first driving method (cf. Abstract).

### Summary of Invention

### Technical Problem

The Patent Literatures 1 to 3 disclose a driving apparatus in which a driven part is integrally supported by a base (or a frame) to which a driving force is applied. In contrast to the conventional driving apparatus, for example, it is an object of the present invention to provide a driving apparatus configured to drive the driven object in a new aspect.

### Solution to Problem

The present invention provides a driving apparatus according to claim 1. Further embodiments of the invention are described in the dependent claims.

### Brief Description of Drawings

FIG. 1 is a plan view illustrating a configuration of a MEMS scanner according to a first example when seen from a front side.
FIG. 2 is a plan view illustrating the configuration of the MEMS scanner according to the first example when seen from a rear side.
FIG. 3 is a cross sectional view illustrating a layered structure of the MEMS scanner according to the first example.
FIG. 4A and FIG. 4B are cross sectional views (ver. 1) conceptually illustrating an aspect of an operation of a first base of the MEMS scanner according to the first example.
FIG. 5A and FIG. 5B are cross sectional views (ver. 2) conceptually illustrating an aspect of the operation of the first base of the MEMS scanner according to the first example.
FIG. 6A to FIG. 6C are side views conceptually illustrating an aspect of an operation of the MEMS scanner according to the first example.
FIG. 7 is an enlarged cross sectional view illustrating a configuration near a boundary of a support layer of a MEMS scanner according to a first comparative example.
FIG. 8 is an enlarged cross sectional view illustrating a configuration of a spring part of the MEMS scanner according to the first example.
FIG. 9 is an enlarged cross sectional view illustrating a configuration of a spring part of a MEMS scanner according to a first modified example.
FIG. 10 is an enlarged cross sectional view illustrating a configuration of a spring part of a MEMS scanner according to a second modified example.
FIG. 11 is an enlarged cross sectional view illustrating a configuration of a spring part of a MEMS scanner according to a third modified example.
FIG. 12 is a plan view illustrating a configuration of a MEMS scanner according to a second example.
FIG. 13 is a cross sectional view illustrating the configuration of the MEMS scanner according to the second example.
FIG. 14 is a plan view illustrating a configuration of a MEMS scanner according to a second comparative example.
FIG. 15 is a cross sectional view illustrating the configuration of the MEMS scanner according to the second comparative example.
FIG. 16 is a plan view illustrating a configuration of a MEMS scanner according to a third example.
FIG. 17A and FIG. 17B are side views conceptually illustrating an aspect of an operation of the MEMS scanner according to the third example.

### Description of Embodiments

Hereinafter, a driving apparatus according to an embodiment will be explained in order.

### <1>

The driving apparatus according to the embodiment provide with: a first base part; a second base part; an elastic part configured to couple the first base part with the second base part; and a driven part supported by the second base part in a drivable aspect.

According to the driving apparatus in the embodiment, the first base part and the second base part are directly or indirectly coupled (in other words, connected) by the elastic part having elasticity (e.g. a spring part described later, etc.). Here, due to the elasticity of the elastic part, rigidity of the elastic part is preferably lower than that of one or both of the first base part and the second base part. In other words, it is preferable that the elastic part is deformed relatively more easily than one or both of the first base part and the second base part. To put it more differently, it is preferable that the elastic part is deformed relatively easily, while one or both of the first base part and the second base part are deformed relatively less easily.

The second base part supports the driven part. At this time, the second base part supports the driven part in such a manner that the driven part can be driven (e.g. can be rotated or can be moved). For example, the second base part and the driven part are coupled by the elastic part having elasticity, by which the second base part may support the driven part in a drivable aspect.

The driving apparatus according to the embodiment in such a configuration can preferably drive (e.g. rotate or move) the driven part. In other words, according to the driving apparatus in the embodiment in such a configuration, the driven part can be preferably driven (e.g. rotated or moved). Specifically, for example, if the first base part moves, the second base part, which is coupled with the first base part via the elastic part, also moves in association with the movement of the first base part. If the second base part moves, the driven part, which is supported by the second base part, also moves in association with the movement of the second base part. As a result, the driven part can be preferably driven.

Here, a specific drive aspect of the driven part described above can be understood in view of such a system that two rigid bodies (i.e. corresponding to the first base part and the second base part) are connected by one spring (i.e. corresponding to the elastic part). Such a system is considered to have a plurality of natural vibration modes and respective natural frequencies for the natural vibration modes. In this case, if a force couple is applied to one of the rigid bodies at a frequency corresponding to a predetermined natural frequency, the one rigid body can be rotated. Then, the rotational motion of the one rigid body is transmitted to the other rigid body via the spring as inertia moment. It is thus possible to realize the natural vibration mode corresponding to the predetermined natural frequency.

From the viewpoint of preferably driving the driven part, the first base part and the second base part may be coupled by a structure other than the elastic part (e.g. a structure without elasticity or a structure without such a characteristic that the structure is deformed more easily than the first base part and the second base part). Even in this case, the driven part can be driven in association with the movement of the first base part.

### <2>

In another aspect of the driving apparatus according to the embodiment, wherein said driving apparatus further comprises a driving force applying part configured to apply a driving force for driving the driven part, to the first base part, and the driven part is driven by a driving force transmitted from the first base part to the second base part via the elastic part.

According to this aspect, the first base part moves due to the driving force applied to the first base part. If the first base part moves, the second base part, which is coupled with the first base part, also moves. If the second base part moves, the driven part also moves. As described above, the driven part can be preferably driven by the driving force applied to the first base part (i.e. the driving force substantially transmitted from the first base part via the elastic part).

### <3>

In the aspect in which the driving force applying part is provided, as described above, wherein the first base part can rotate around an axis along a first direction and an axis along a second direction, which is different from the first direction, due to the driving force applied from the driving force applying part, and the driven part can rotate around the axis along the first direction and the axis along the second direction, due to the driving force transmitted from the first base part to the second base part via the elastic part.

In this case, if the first base part rotates around the axis along the first direction, which is a rotation axis, due to the driving force applied from the driving force applying part, then, the driving force caused by the rotation of the first base part is transmitted to the second base part by the elastic part. Then, the second base part also rotates around the axis along the first direction, which is a rotation axis. In the same manner, if the first base part rotates around the axis along the second direction, which is a rotation axis, then, the driving force caused by the rotation of the first base part is transmitted to the second base part by the elastic part. Then, the second base part also rotates around the axis along the second direction, which is a rotation axis.

As described above, the second base part rotates around the rotation axis that has the same direction as that of the rotation axis of the first base part. Thus, if a rotational direction of the first base part is changed, a rotational direction of the second base part (i.e. a rotational direction of the driven part) is also changed. Therefore, the rotational direction of the driven part can be changed by changing the driving force applied to the first base part.

### <4>

Alternatively, in the aspect in which the driving force applying part is provided, wherein the driving force applying part comprises: a coil disposed around an opening of the first base part; and a yoke inserted in the opening of the first base part.

In this case, the first base part is configured to have the opening. For example, the first base part is configured as a frame. Around the opening of the first base part, there is disposed the coil, which functions as a part of the driving force applying part. The coil is wound, for example, around the opening.

On the other hand, in the opening of the first base part, the yoke for focusing a magnetic flux is inserted. The yoke preferably contains a soft magnetic material with high relative permeability, such as, for example, pure iron, permalloy, ferrosilicon, and Sendust. The provision of the yoke in the opening can increase Lorentz force generated by applying control current to the coil. In other words, it is possible to increase the driving force that can be applied by the driving force applying part. It is therefore possible to reduce the size of a magnet or the like, which provides a magnetic flux, and also to reduce the size of an entire apparatus.

In order to increase an effect of focusing the magnetic flux by the yoke, a distance between the yoke and the coil is preferably short. Thus, the yoke is preferably set to be large in a range of not preventing the drive of the first base part on which the coil is disposed. Moreover, a cross section of the yoke preferably has a shape similar to a shape of the opening of the first base part.

Moreover, the yoke is inserted, for example, from a lower side to an upper side of the first base part. In order to increase the effect of focusing the magnetic flux by the yoke, however, the yoke is preferably configured to extend upwardly to some extent. Thus, the yoke is preferably configured to be long in a range of not preventing the drive of the first base part on which the coil is disposed.

### Examples

Hereinafter, a driving apparatus according to examples of the present invention will be explained with reference to the drawings. Hereinafter, an explanation will be given to an example in which the driving apparatus is applied to a MEMS scanner. Needles to say, the driving apparatus according to the present invention may be applied to an arbitrary driving apparatus other than the MEMS scanner.

### (1) First Example

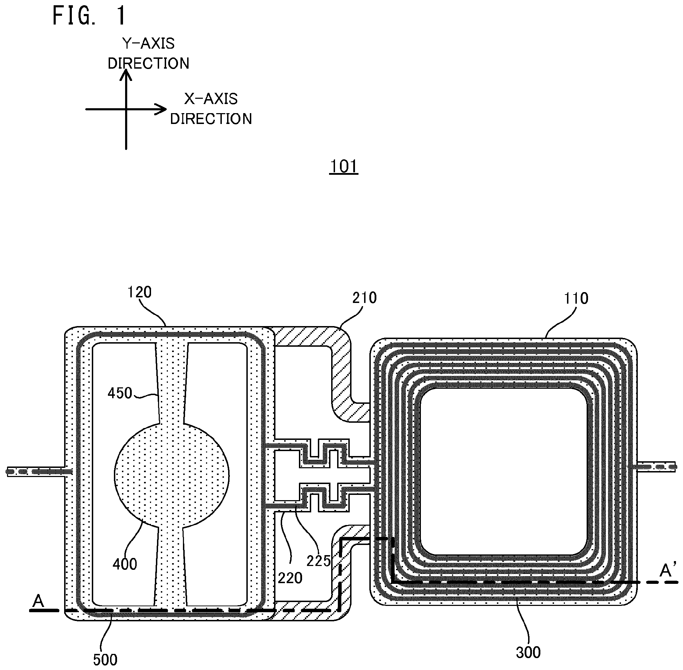

Firstly, a MEMS scanner 101 according to a first example will be explained with reference to FIG. 1 to FIG. 11.

### (1-1) Basic Configuration

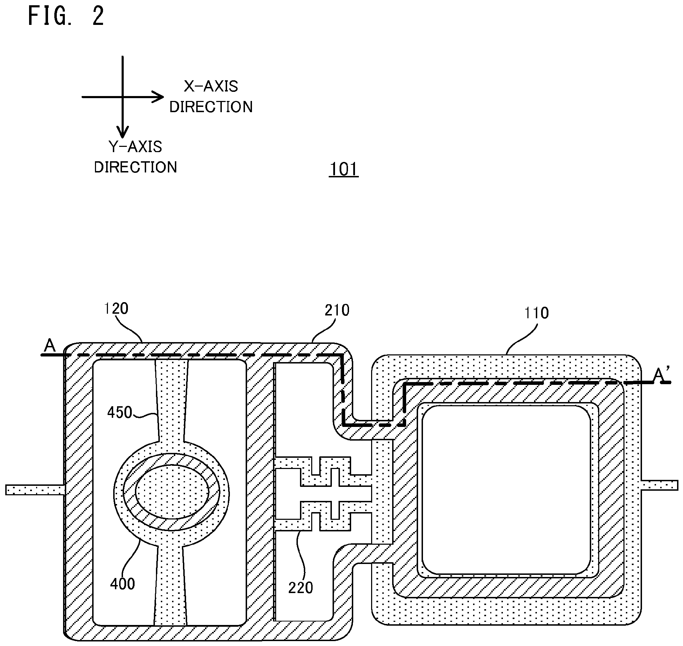

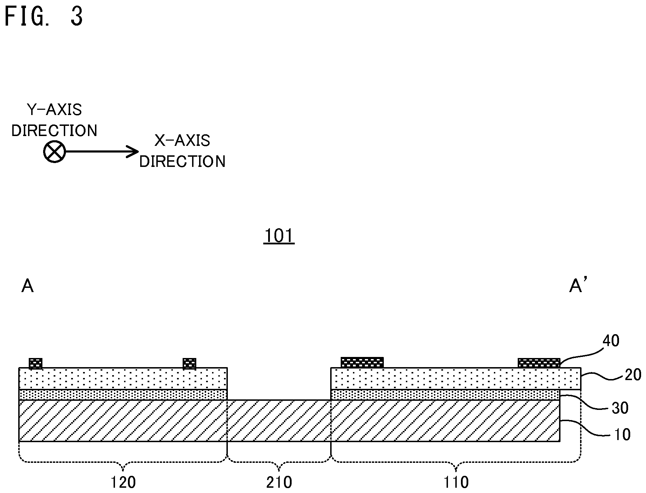

Firstly, with reference to FIG. 1 to FIG. 3, a configuration of the MEMS scanner 101 according to the first example will be explained. FIG. 1 is a plan view conceptually showing the basic configuration of the MEMS scanner 100 in the first example. FIG. 1 is a plan view illustrating the configuration of the MEMS scanner 101 according to the first example when seen from a front side. FIG. 2 is a plan view illustrating the configuration of the MEMS scanner 101 according to the first example when seen from a rear side. FIG. 3 is a cross sectional view illustrating a layered structure of the MEMS scanner 101 according to the first example.

As illustrated in FIG. 1 and FIG. 2, the MEMS scanner 101 according to the first example is provided with a first base 110, a second base 120, a spring part 210, a wiring spring part 220, a coil 330, a mirror 400, and a torsion bar 450.

The first base 110 has a frame shape with a space (or an opening) therein. In other words, the first base 110 has a frame shape that has two sides extending in a Y-axis direction in FIG. 1 and two sides extending in an X-axis direction (i.e. in an axial direction perpendicular to the Y-axis direction) in FIG. 1, and that has a space surrounded by the two sides extending in the Y-axis direction and the two sides extending in the X-axis direction. In the example illustrated in FIG. 1 and FIG. 2, the first base 110 has, but not limited to, a square shape. For example, the first base 110 may have another shape (e.g. rectangular shape such as an oblong shape, a circular shape, etc.).

The first base 110 is fixed to a not-illustrated substrate or support member (in other words, is fixed in the inside of a system which is the MEMS scanner 101). Alternatively, the first base 110 may be hung by a not-illustrated suspension or the like.

On the first base 110, the coil 300 is disposed. The coil 300 is a wound wire that is wound a plurality of times and that contains, for example, a relatively highly conductive material (e.g. gold, copper, etc.). In the first example, the coil 300 has a square shape along the first base 110. The coil 300, however, may have an arbitrary shape (e.g. an oblong, rhomboid, parallelogram, circular, oval, or another arbitrary loop shape).

A control current is supplied to the coil 300 from a power supply via a not-illustrated power supply terminal or the like. The power supply may be a power supply provided for the MEMS scanner 101, or may be a power supply provided outside the MEMS scanner 101. A not-illustrated magnet is disposed around the coil 300, and a force in a rotational direction is applied due to an interaction between a magnetic field generated by applying the control current to the coil 300 and a magnetic field of the magnet. As a result, the first base 110 provided with the coil 300 is rotated in a direction according to the magnetic field and the direction of the control current. The coil 300 is one specific example of the "driving force applying part".

The second base 120 has a frame shape with a space therein, as in the first base 110. In the space of the second base 120, the mirror 400 is disposed. The mirror 400 is disposed to be hung or supported by the torsion bar 450.

The torsion bar 450 is an elastic member, such as a spring that contains, for example, silicone, copper alloy, iron-based alloy, other metal, resin, or the like. The torsion bar 450 is disposed to extend in the Y-axis direction in FIG. 1. In other words, the torsion bar 450 has a shape having long sides extending in the Y-axis direction and short sides extending in the X-axis direction. One end of the torsion bar 450 is connected to the second base 120. The other end of the torsion bar 450 is connected to the mirror 400. Thus, the mirror 400 can rotate around an axis along the Y-axis direction, which is a rotation axis, by the elasticity of the torsion bar 450. The mirror 400 is one specific example of the "driven part".

The first base 110 and the second base 120 are connected to each other by the spring part 210. The spring part 210 is one specific example of the "elastic part", and has a function of transmitting a driving force obtained from the coil 300 on the first base 110, to the second base 120. Moreover, the wiring spring part 220 is provided between the first base 110 and the second base 120. The wiring spring part 220 is provided to realize electrical connection between the first base 110 and the second base 120. Specifically, a connection wire 225 for connecting the coil 300 of the first base 110 and a wire 500 of the second base 120 is disposed on the wiring spring part 220.

As illustrated in FIG. 3, the MEMS scanner 101 according to the first example has a laminated structure of a support layer 10, an active layer 20, a BOX layer 30, and a metal layer 40. The MEMS scanner 101, however, may have a laminated structure including another layer.

Each of the support layer 10 and the active layer 20 contains, for example, silicon or the like. The BOX layer 30 contains an oxide film or the like, such as, for example, SiO₂, and is disposed between the support layer 10 and the active layer 20. The BOX layer 30 insulates the support layer 10 and the active layer 20. The metal layer 40 contains, for example, highly conductive metal, and is placed on the active layer 20. The metal layer 40 constitutes the coil 300 of the first base 110, the wire 400 of the second base 120, the connection wire 225 of the wiring spring part 220, or the like.

Particularly in the first example, the support layer 10 is formed to extend from the first base 110 to the spring part 210 and the second base 120 (specifically refer to FIG. 2). On the other hand, the active layer 20, the BOX layer 30, and the metal layer 40 are formed in both of the first base 110 and the second base 120, but are not formed in the spring part 210. In other words, the spring part 210 only includes the support layer 20. Moreover, the spring part 210 is integrally configured with the support layer 10 of the first base 110 and the support layer of the second base 120. The active layer 20 is not formed in the spring part 210, but the active layer 20 is formed in the wiring spring part 220 (refer to FIG. 1). This can realize the electrical connection between the first base 110 and the second base 120.

### (1-2) Operation of MEMS Scanner

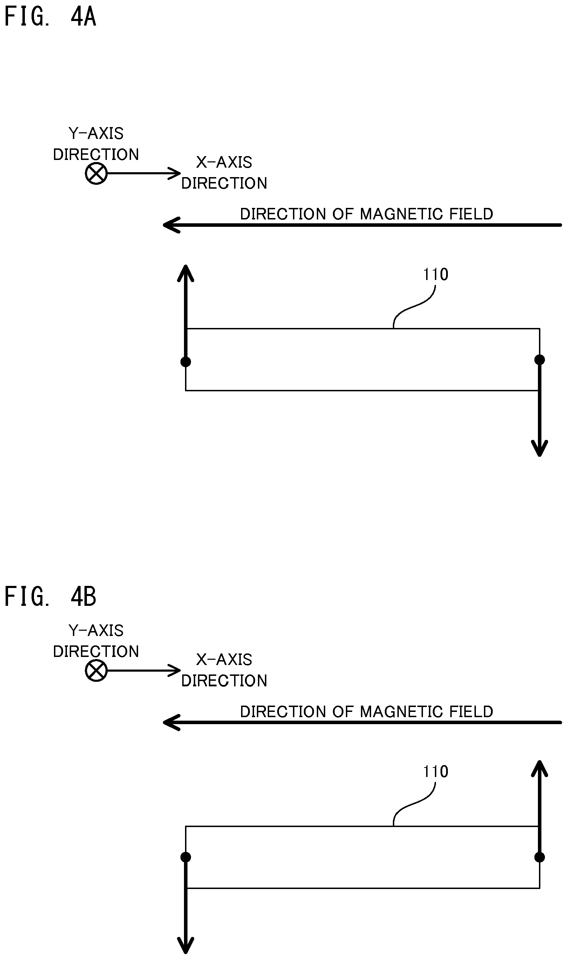

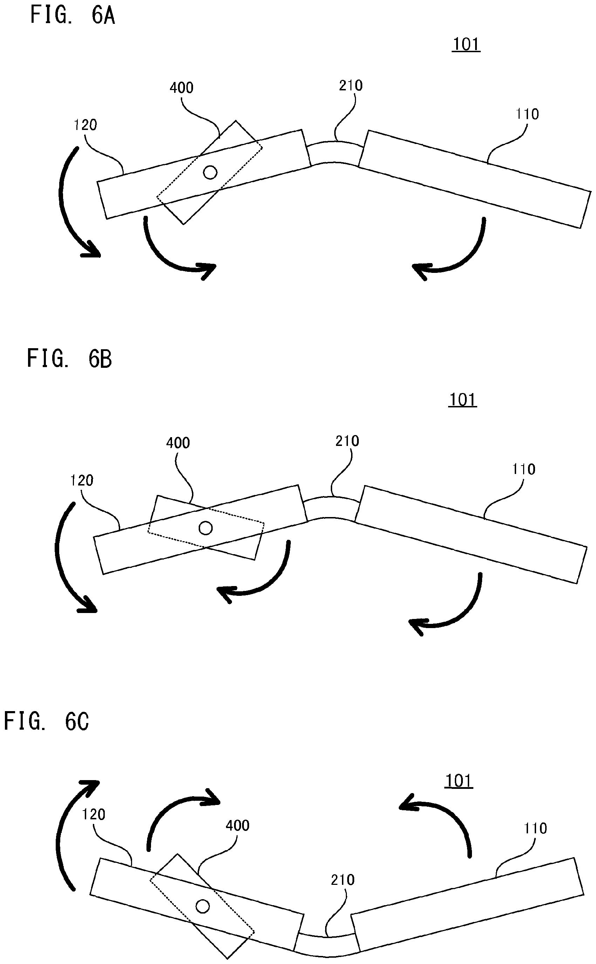

Next, with reference to FIG. 4A to FIG. 6C, the operation of the MEMS scanner 101 according to the first example will be explained. FIG. 4A to FIG. 5B are respectively cross sectional views conceptually illustrating an aspect of the operation of the first base of the MEMS scanner 101 according to the first example. FIG. 6A to FIG. 6C are side views conceptually illustrating an aspect of the operation of the MEMS scanner 101 according to the first example. In the drawings after FIG. 4, for convenience of explanation, the detailed members that constitute the MEMS scanner 101 described in FIG. 1 to FIG. 3 or the like will be omitted, as occasion demands, and will be simply illustrated.

In operation of the MEMS scanner 101 according to the first example, firstly, the control current is supplied to the coil 300. The control current includes a current component for rotating the first base 110 around the axis along the Y-axis direction, which is a rotation axis (i.e. a Y-axis driving control current).

As illustrated in FIG. 4A and FIG. 4B, a magnetic field in an X-axis minus direction is applied to the coil 300 by the magnet. Therefore, Lorentz force caused by an electromagnetic interaction between an X-axis driving control current supplied to the coil 300 and the Y-axis driving magnetic field applied to the coil 300 is generated in the coil 300.

Now, an explanation will be given to a case where the Y-axis driving control current, which flows in a clockwise direction in FIG. 1, is supplied to the coil 300. In this case, a Lorentz force directed to a lower side in FIG. 4A is generated on a long side on a right side (i.e. on an upper side in FIG. 1) out of two long sides of the coil 300 illustrated in FIG. 4A. In the same manner, as illustrated in FIG. 4A, a Lorentz force directed to an upper side in FIG. 4A is generated on a long side on a left side (i.e. on a lower side in FIG. 1) out of the two long sides of the coil 300. In other words, the Lorentz forces in the different directions are generated on the two long sides of the coil 300, which are opposite to each other in the X-axis direction. To put it differently, the Lorentz forces, which are force couples, are generated on the two sides of the coil 300, which are opposite to each other in the X-axis direction. Therefore, the coil 300 rotates in a clockwise direction in FIG. 4A.

On the other hand, since the control current is alternating current, the Y-axis driving control current may be also supplied to the coil 300 in a counterclockwise direction in FIG. 1, in some cases. In this case, as illustrated in FIG. 4B, a Lorentz force directed to an upper side in FIG. 4B is generated on the long side on the right side (i.e. on the upper side in FIG. 1) out of the two long sides of the coil 300, which are opposite to each other in the X-axis direction. In the same manner, as illustrated in FIG. 4B, a Lorentz force directed to a lower side in FIG. 4B is generated on the long side on the left side (i.e. on the lower side in FIG. 1) out of the two long sides of the coil 300, which are opposite to each other in the X-axis direction. In other words, the Lorentz forces in the different directions are generated on the two long sides of the coil 300, which are opposite to each other in the X-axis direction. To put it differently, the Lorentz forces, which are force couples, are generated on the two sides of the coil 300, which are opposite to each other in the X-axis direction. Therefore, the coil 300 rotates in a counterclockwise direction in FIG. 4B.

Due to the Lorentz forces, the coil 300 rotates (or more specifically, the coil 300 reciprocates so as to rotate) around the axis along the Y-axis direction, which is a rotation axis

On the other hand, in operation of the MEMS scanner 101 according to the first example, the control current including a current component for rotating the first base 110 around an axis along the X-axis direction, which is a rotation axis (i.e. the X-axis driving control current), is supplied to the coil 300.

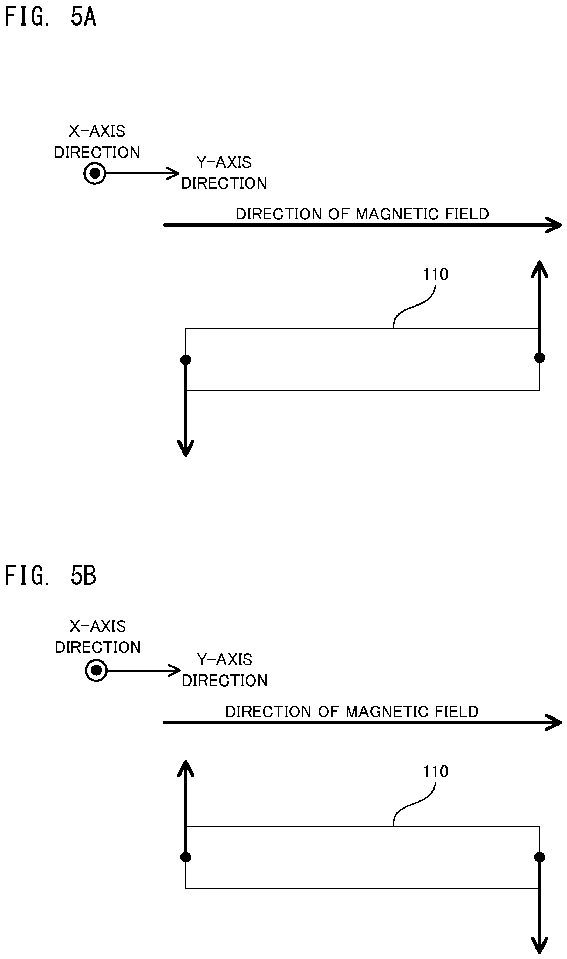

As illustrated in FIG. 5A and FIG. 5B, a magnetic field in a Y-axis plus direction is applied to the coil 300 by the magnet. Therefore, Lorentz force caused by an electromagnetic interaction between the X-axis driving control current supplied to the coil 300 and the X-axis driving magnetic field applied to the coil 300 is generated in the coil 300.

Now, an explanation will be given to a case where the X-axis driving control current, which flows in the clockwise direction in FIG. 1, is supplied to the coil 300. In this case, a Lorentz force directed to an upper side in FIG. 5A is generated on the long side on the right side out of the two long sides of the coil 300. In the same manner, as illustrated in FIG. 5A, a Lorentz force directed to a lower side in FIG. 5A is generated on the long side on the left side out of the two long sides of the coil 300. In other words, the Lorentz forces in the different directions are generated on the two long sides of the coil 300, which are opposite to each other in the Y-axis direction. To put it differently, the Lorentz forces, which are force couples, are generated on the two sides of the coil 300, which are opposite to each other in the Y-axis direction. Therefore, the coil 300 rotates in a counterclockwise direction in FIG. 5A.

On the other hand, since the control current is alternating current, the X-axis driving control current may be also supplied to the coil 300 in the counterclockwise direction in FIG. 1, in some cases. In this case, as illustrated in FIG. 5B, a Lorentz force directed to a lower side in FIG. 5B is generated on the long side on the right side out of the two long sides of the coil 300, which are opposite to each other in the Y-axis direction. In the same manner, as illustrated in FIG. 5B, a Lorentz force directed to an upper side in FIG. 5B is generated on the long side on the left side out of the two long sides of the coil 300, which are opposite to each other in the Y-axis direction. In other words, the Lorentz forces in the different directions are generated on the two long sides of the coil 300, which are opposite to each other in the Y-axis direction. To put it differently, the Lorentz forces, which are force couples, are generated on the two sides of the coil 300, which are opposite to each other in the Y-axis direction. Therefore, the coil 300 rotates in a clockwise direction in FIG. 5B.

Due to the Lorentz forces, the coil 300 rotates (or more specifically, the coil 300 reciprocates so as to rotate) around the axis along the X-axis direction, which is a rotation axis.

The rotation operation of the coil 300 explained above is transmitted from the first base 110 to the second base 120 via the spring part 210. By this, the second base 120 is driven. In other words, the second base 120 is driven by the driving force on the first base 110, which is applied to the coil 300.

As illustrated in FIG. 6A to FIG. 6C, particularly if the coil 300 performs the rotation operation (refer to FIG. 5A and FIG. 5B) around the axis along the X-axis direction, which is a rotation axis, the mirror 400 is significantly driven in the rotational direction around the axis along the X-axis direction, which is a rotation angle.

Specifically, as illustrated in FIG. 6A and FIG. 6B, if the first base 110 rotates in a clockwise direction, the second base 120 rotates in a counterclockwise direction. By this, as illustrated in FIG. 6A, the mirror 400 disposed on the second base 120 significantly rotates in the counterclockwise direction (i.e. in the same rotational direction as that of the second base 120). Alternatively, as illustrated in FIG. 6B, the mirror 400 disposed on the second base 120 significantly rotates in the clockwise direction (i.e. in the different rotational direction from that of the second base 120). The rotation as illustrated in FIG. 6A or the rotation as illustrated in FIG. 6B can be selected depending on design, such as hardness or rigidity of a spring in each part.

On the other hand, as illustrated in FIG. 6C, if the first base 110 rotates in the counterclockwise direction, the second base 120 rotates in the clockwise direction. By this, the mirror disposed on the second base 120 significantly rotates in the clockwise direction (i.e. in the same direction as that of the second base 120).

### (1-3) Stress Concentration In Driving MEMS

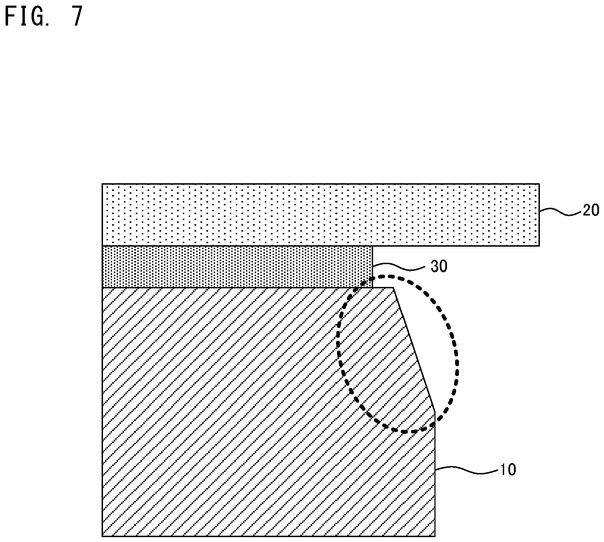

Next, with reference to FIG. 7 in addition to FIG. 6 described above, an explanation will be given to a problem that can occur in driving the MEMS scanner. FIG. 7 is an enlarged cross sectional view illustrating a configuration near a boundary of a support layer of a MEMS scanner according to a first comparative example.

In driving the MEMS scanner 101 as illustrated in FIG. 6, the driving force generated on the coil 300 of the first base 110 is transmitted to the mirror 400 of the second base 120 via the spring part 210. As is clear from FIG. 6A to FIG. 6C, the spring part 210 is significantly deformed due to the drive. The shape and hardness or rigidity of the spring part 210 are significantly influenced by an aspect of a drive resonance mode and resonance frequency thereof, and thus, the shape and hardness or rigidity suitable to satisfy desired device characteristics are desired. Moreover, the spring part 210 is also desired to satisfy requirements regarding strength (e.g. strength that does not allow damage by the deformation or the like due to the drive).

Here, in particular, stress tends to be concentrated around the boundary between the spring part 210 and the first base 110 or the second base 120 if the driving force is transmitted. Thus, the spring part 210 that does not have a certain level of strength is possibly damaged in driving near the boundary between the first base 110 and the second base 120.

Here, as illustrated in FIG. 7, consideration is made on a first comparison example in which the support layer 10 is not integrally formed. In other words, consideration is made on an example in which the support layer is not formed to extend from the first base 110 to the spring part 210 and the second base 120, and the support layer partially does not exist, unlike the first example (refer to FIG. 3),

In the first comparative example, as described above, the support layer 10 is not integrally formed, and there is thus the boundary of the support layer 10 as illustrated in FIG. 7. In the boundary portion of the support layer 10, for convenience of processing, there tends to be a notch as in an area surrounded by a dashed line in FIG. 7. Thus, the shape becomes weaker against stress.

In contrast, in the MEMS canner 101 according to the first example, as illustrated in FIG. 3 or the like, the spring part 210 on which stress tends to be concentrated is integrally configured by the same layer as the support layers 10 of the first base 110 and the second base 120. It is thus possible to effectively prevent the damage due to the stress concentration, as described above.

Moreover, in the MEMS scanner 101 according to the first example, as illustrated in FIG. 3 or the like, the spring part 210 only includes the support layer 10. It is thus possible to effectively prevent that the spring part 210 is damaged due to the stress concentration in driving in the boundary portion between the support layer 10 and another layer (e.g. the active layer 20 and the BOX layer 30). Even if, however, the spring part 210 includes more than a single layer (e.g. if the spring part 210 includes the BOX layer 30 or the like), an effect of improving damage resistance can be appropriately obtained as long as the spring part 210 is integrally configured by the same layers of the first base 110 and the second base 120.

### (1-4) Specific Configuration of Spring Part

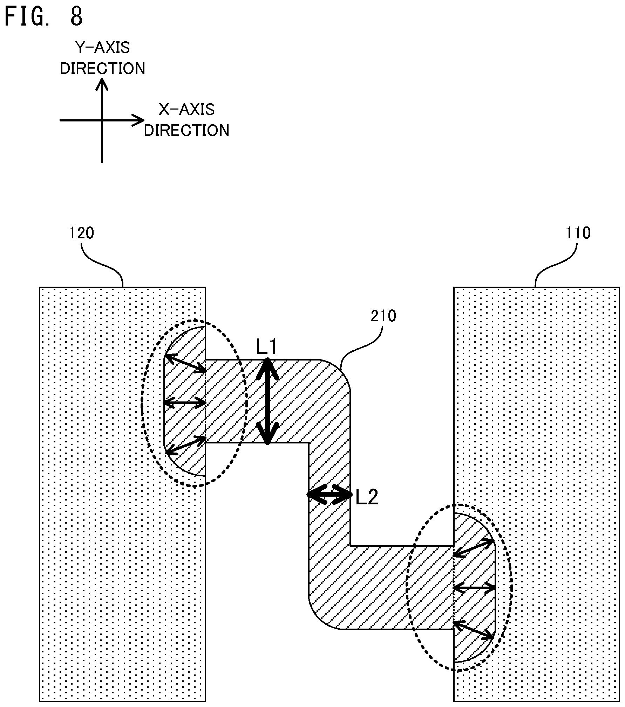

Next, with reference to FIG. 8, a specific configuration of the spring part 210 according to the first example will be explained in detail. FIG. 8 is an enlarged cross sectional view illustrating the configuration of the spring part of the MEMS scanner according to the first example.

As illustrated in FIG. 8, the spring part 210 of the MEMS scanner 101 according to the first example has portions extending in a direction along the X-axis direction (hereinafter referred to as "first portions" as occasion demands) and a portion extending in a direction along the Y-axis direction (hereinafter referred to as a "second portion" as occasion demands). Specifically, the first portions are respectively connected to the first base 110 and the second base 120, and the second portion is provided between the two first portions.

This shape can reduce the stress concentration and can effectively increase the damage resistance, because the spring part 210 has the first portions and the second portion that extend in the different directions. Specifically, since the second portion extending in a direction crossing a connection direction (i.e. in the direction along the Y-axis direction) bends (or twists), the damage can be effectively prevented.

Particularly in the first example, a width L1 of the first portion described above is formed to be thicker than a width L2 of the second portion. In this manner, the first portion extending in the connection direction (i.e. in the direction along the X-axis direction) is formed to be relatively thick, and thus, the strength as a connecting member can be effectively increased. On the other hand, the second portion extending in the direction crossing the connection direction (i.e. in the direction along the Y-axis direction) is formed to be relatively narrow, and thus tends to bend more easily. It is therefore possible to effectively increase the damage resistance.

In addition, in the first example, a connecting portion between the spring part 210 and the first base 110 and a connecting portion between the spring part 210 and the second base 120 are respectively provided with areas in which the active layer 20 partially does not extend (refer to areas surrounded by dashed lines in FIG. 8). In this case, it is possible to prevent that there is a boundary of the active layer 20 having low damage resistance in the connecting portions on which stress tends to be concentrated. It is therefore possible to more effectively increase the damage resistance.

As explained above, according to the spring part 210 in the first example, the damage in driving can be effectively suppressed.

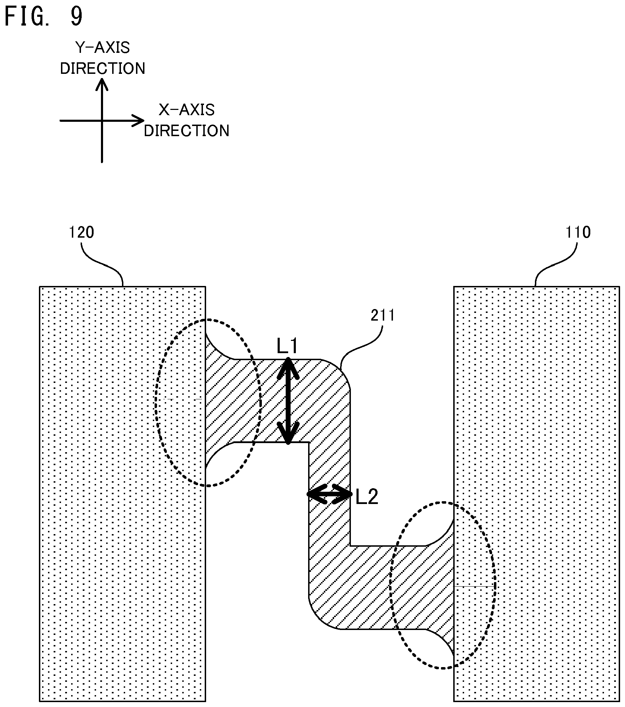

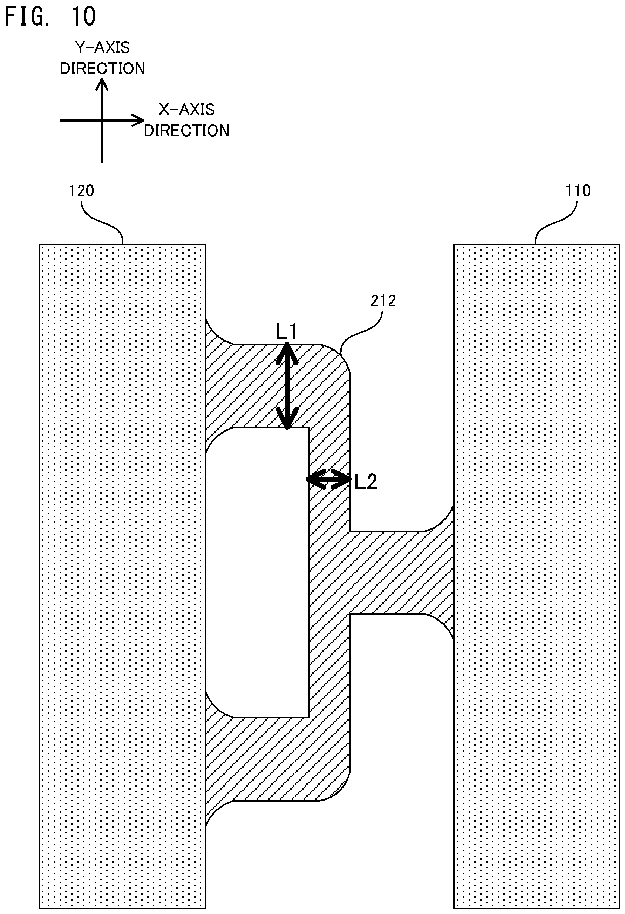

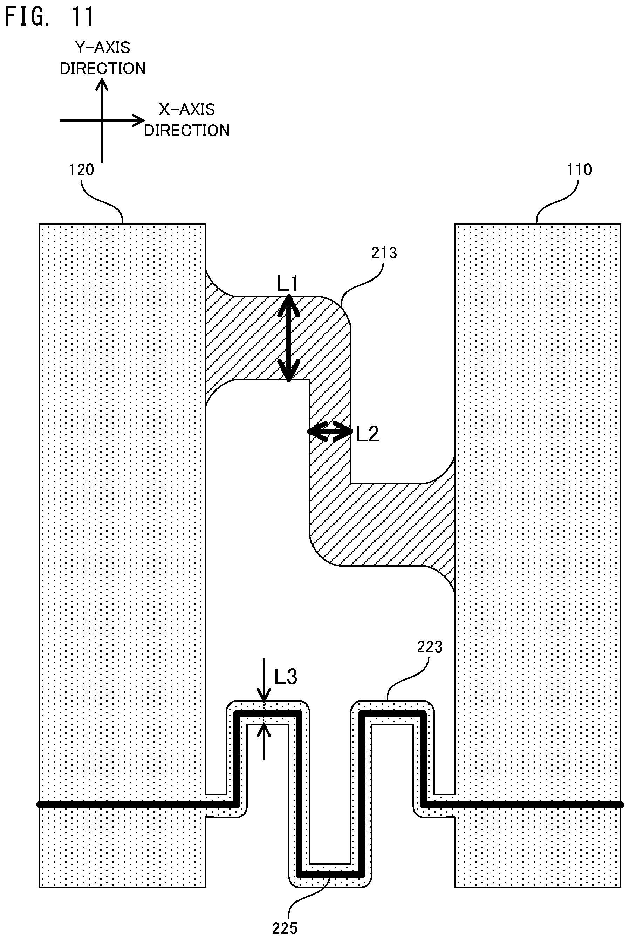

The structure of the spring part 210 is not limited to the structure illustrated in FIG. 8. Hereinafter, with reference to FIG. 9 to FIG. 11, modified examples of the spring part described above will be explained. FIG. 9 is an enlarged cross sectional view illustrating a configuration of a spring part of a MEMS scanner according to a first modified example. FIG. 10 is an enlarged cross sectional view illustrating a configuration of a spring part of a MEMS scanner according to a second modified example. FIG. 11 is an enlarged cross sectional view illustrating a configuration of a spring part of a MEMS scanner according to a third modified example.

As illustrated in FIG. 9, a spring part 211 according to the first modified example is formed to be thicker in connecting portions with the first base 110 and the second base 120 in the first portion (refer to areas surrounded by dashed lines in FIG. 9. By virtue of such a configuration, the connecting portions on which stress particularly tends to be concentrated in the first portions are formed to be thick, and it is thus possible to effectively increase the damage resistance.

As illustrated in FIG. 10, a spring part 212 according to the second modified example is configured in such a manner that two spring parts are integrally configured. In other words, the two spring parts disposed on symmetric positions when the MEMS scanner 101 is seen in the direction along the X-axis direction in FIG. 1 and the like are configured as one spring part. Specifically, one first portion extending from the first bas 110 and two first portions extending from the second base 120 are connected to each other by one second portion. Even in such a configuration, the effect of improving the damage resistance can be obtained by setting the first portion and the second portion to have the various configurations described above.

As illustrated in FIG. 11, a spring part 213 according to the third modified example is configured to have the same shape as that of the spring part 211 according to the first modified example. On the other hand, the third modified example is configured in such a manner that a width L3 of the wiring spring part 223 has a width L3, which is smaller than a width L2 of the spring part 213. Moreover, a whole length of the wiring spring part 223 when extended is configured to be longer than a whole length of the spring part 213 when extended. By virtue of such a configuration, the wiring spring part 223 can be made flexible. It is thus possible to effectively increase the damage resistance of the wiring spring part 223, which only includes the active layer 20, unlike the spring part 213.

Parts of the respective configurations explained in the first example and the first modified example to the third modified example may be combined, as occasion demands. Even in this case, various effects corresponding to the various configurations described above can be preferably received.

### (2) Second Example

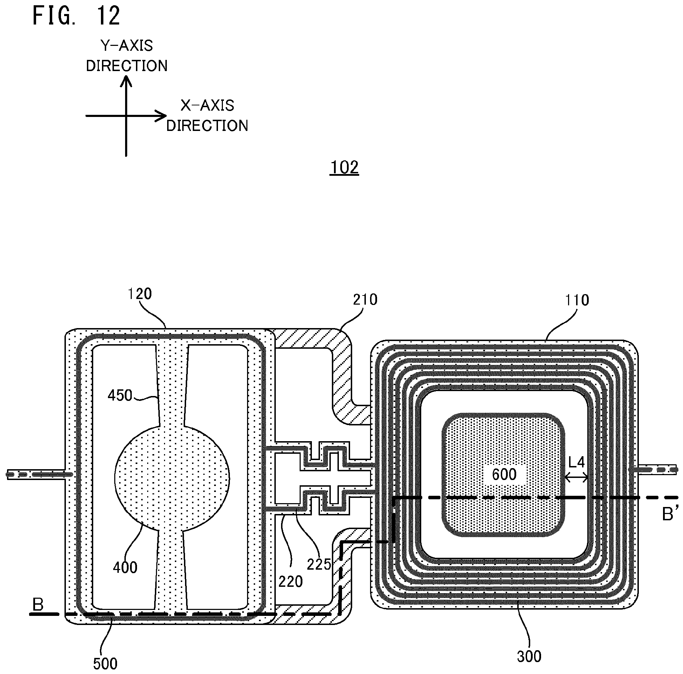

Next, a MEMS scanner 102 according to a second example will be explained with reference to FIG. 12 to FIG. 15. The second example is different from the first example described above in a partial configuration, and is substantially the same in the other configuration. Thus, hereinafter, the different part from that of the first example will be explained in detail, and an explanation of the other same part will be omitted, as occasion demands.

### (2-1) Basic Configuration

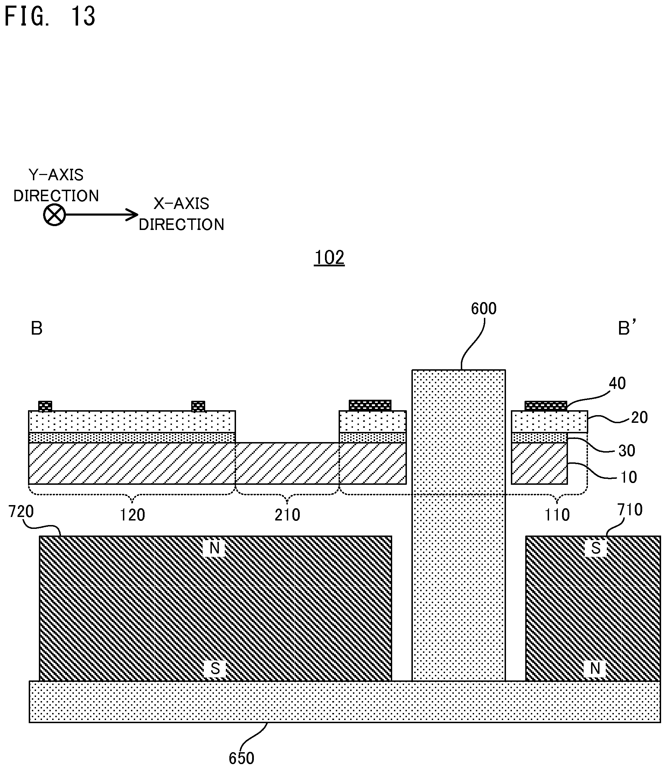

Firstly, a configuration of the MEMS scanner 102 according to the second example will be explained with reference to FIG. 12 and FIG. 13.

FIG. 12 is a plan view illustrating the configuration of the MEMS scanner according to the second example. FIG. 13 is a cross sectional view illustrating the configuration of the MEMS scanner according to the second example.

In FIG. 12, the MEMS scanner 102 according the second example is provided with a yoke 600, which is inserted in the opening of the first base 110, in addition to the configuration of the MEMS scanner 101 according to the first example (e.g. refer to FIG. 1). The yoke 600 preferably contains a soft magnetic material with high relative permeability, such as, for example, pure iron, permalloy, ferrosilicon, and Sendust.

In FIG. 13, the yoke 600 is formed to extend toward an upper side of the MEMS scanner 101 from a lower yoke 650 disposed on a lower side of the MEMS scanner 101. On a lateral side of the yoke 600, there are disposed a first magnet 710 and a second magnet 720, which generate a magnetic flux. The first magnet 710 has an S pole on an upper surface (i.e. a surface opposite to the MEMS scanner 102), and the second magnet 720 has an N pole (i.e. a pole different from that of the first magnet 710) on the upper surface. Thus, the magnetic flux is directed from the upper surface of the second magnet 720 to the upper surface of the first magnet 710. A not-illustrated middle yoke may be provided on an upper surface side of the first magnet 710 and the second magnet 720. Moreover, a not-illustrated yoke post may be provided on an outer side of the coil 300.

By disposing the yoke 600, the magnetic flux generated by the first magnet 710 and the second magnet 720 described above can be focused. This can increase the Lorentz force generated by applying the control current to the coil 300. In other words, according to the yoke 600, without increasing the coil 300, the first magnet 710, and the second magnet 720, the driving force that can be applied to the first base 110 can be increased. This makes it possible to reduce the size of the apparatus.

In order to increase an effect of focusing the magnetic flux by the yoke 600, a distance L4 between the yoke 600 and the coil 300 (refer to FIG. 12) is preferably short. Thus, the yoke 600 is preferably set to be large in a range of not preventing the drive of the first base 110 on which the coil 300 is disposed. Moreover, a cross section of the yoke 600 preferably has a shape similar to a shape of the opening of the first base 110.

Moreover, in order to increase the effect of focusing the magnetic flux by the yoke 600, the yoke 600 is preferably configured to extend upwardly over the MEMS scanner 102 to some extent. Thus, the yoke 600 is preferably configured to be long in a range of not preventing the drive of the first base 110 on which the coil 300 is disposed, or in a range of not preventing a path of laser light that enters the mirror 400.

### (2-2) Comparison with Second Comparative Example

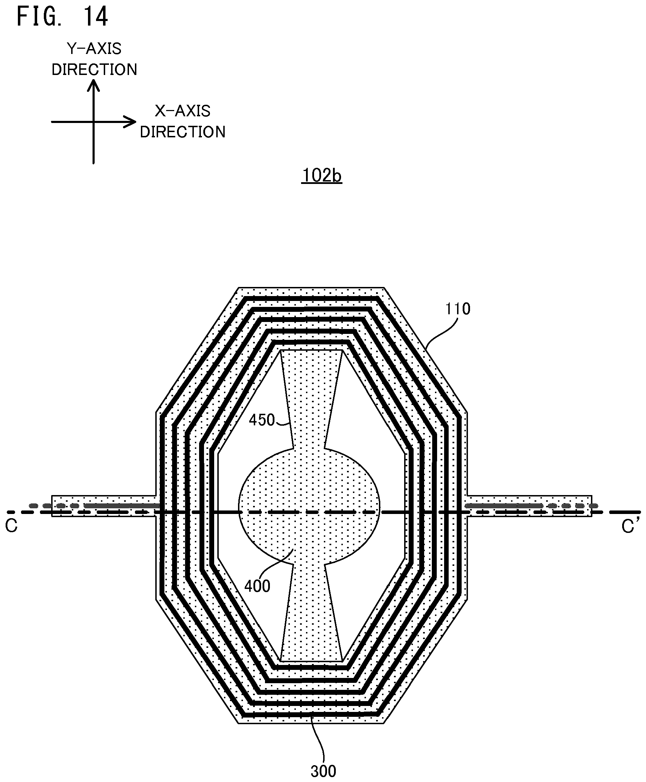

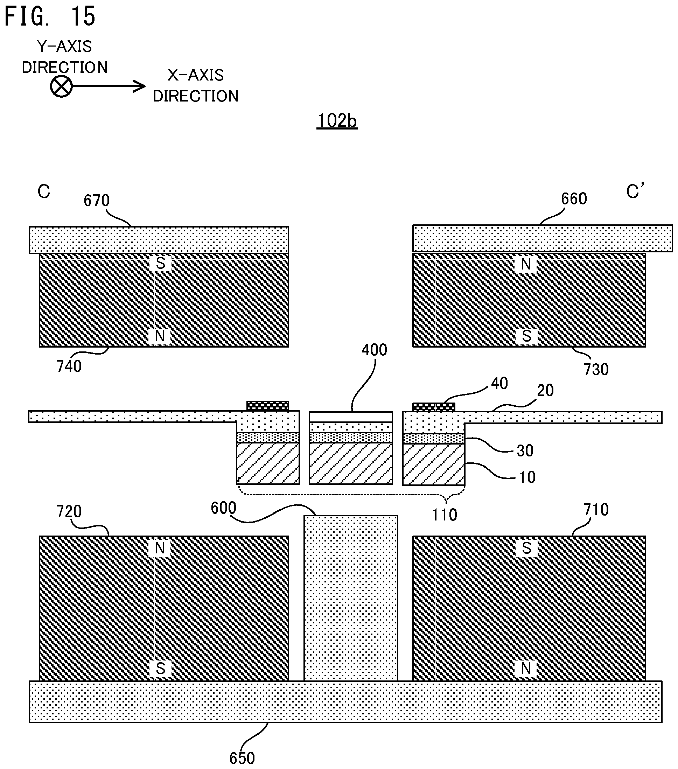

Next, an advantageous point of the MEMS scanner 102 according to the second example will be specifically explained, in comparison with a MEMS scanner 102b according to a second comparative example, which is explained with reference to FIG. 14 and FIG. 15. FIG. 14 is a plan view illustrating a configuration of the MEMS scanner according to the second comparative example. FIG. 15 is a cross sectional view illustrating the configuration of the MEMS scanner according to the second comparative example.

In FIG. 14, the MEMS scanner 102b according to the second comparative example is provided with the mirror 400 on the first base 110 on which the coil 300 is disposed. More specifically, the mirror 400 according to the second comparative example is supported by the torsion bar 450 in the opening of the first base 110. According to such a configuration, if the first base 110 is driven by a driving force applied by the coil 300, the mirror 400 is also driven in association with the drive of the first base 110.

In FIG. 15, in the MEMS scanner 102b according to the second comparative example, the mirror 400 is disposed in the opening of the first base 110, and thus, the yoke 600 cannot be inserted, unlike the MEMS scanner 102 according to the second example (refer to FIG. 13). In other words, in the MEMS scanner 102b according to the second comparative example, the yoke 600 can extend only below the MEMS scanner 102b. Thus, the MEMS scanner 102b according to the second comparative example has a lower effect of focusing the magnetic flux by the yoke 600 than that of the MEMS scanner 102 according to the second example.

Therefore, for example, in the MEMS scanner 102b according to the second comparative example, if it is desired to apply the same driving force as that of the MEMS scanner 102 according to the second example, it is required to increase the size of the coil 300, the first magnet 710, and the second magnet 720. Alternatively, as illustrated in FIG. 15, it is required to dispose another magnetic flux generating device (specifically, a third magnet 730, a fourth magnet 740, a first upper yoke 660, and a second upper yoke 670) over the MEMS scanner 102b. In such a design change, it is hard to avoid the increase in size of the apparatus.

As explained above, according to the MEMS scanner 102 in the second example, the yoke 600 can be inserted in the opening of the first base 110. It is thus possible to increase the effect of focusing the magnetic flux, extremely effectively, while avoiding the increase in size of the apparatus. Therefore, even if an apparatus that has a high driving force is required, the reduction in size of the apparatus can be realized.

### (3) Third Example

Next, a MEMS scanner 103 according to a third example will be explained with reference to FIG. 6 and FIG. 7. The third example is different from the second example described above in a partial configuration and operation, and is substantially the same in the other configuration. Thus, hereinafter, the different part from that of the second example will be explained in detail, and an explanation of the other same part will be omitted, as occasion demands.

### (3-1) Basic Configuration

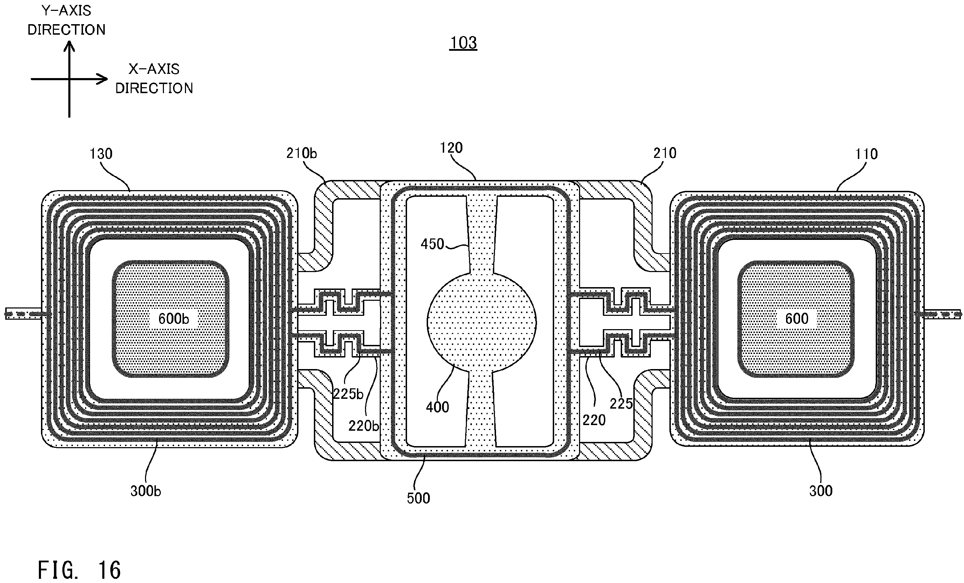

Firstly, a configuration of the MEMS scanner 103 according to the third example will be explained with reference to FIG. 16. FIG. 16 is a plan view illustrating the configuration of the MEMS scanner according to the third example.

In FIG. 16, the MEMS scanner 103 according to the third example is provided with a third base 130 on an opposite side to the first base 110 when seen from the second base 120. The third base 130 is provided with a coil 300b as in the first base 110, and a yoke 600b is inserted in the opening. Moreover, the third base 130 is physically connected to the second base 120 by a spring part 210b and a wiring spring part 220b, and is also electrically connected to the second base 120 by a connection wire 225b disposed on a wiring spring part 220b. In other words, the third base 130 is configured to transmit a driving force to the mirror 400 supported by the second base 120, as in the first base 110.

### (3-2) Operation of MEMS Scanner

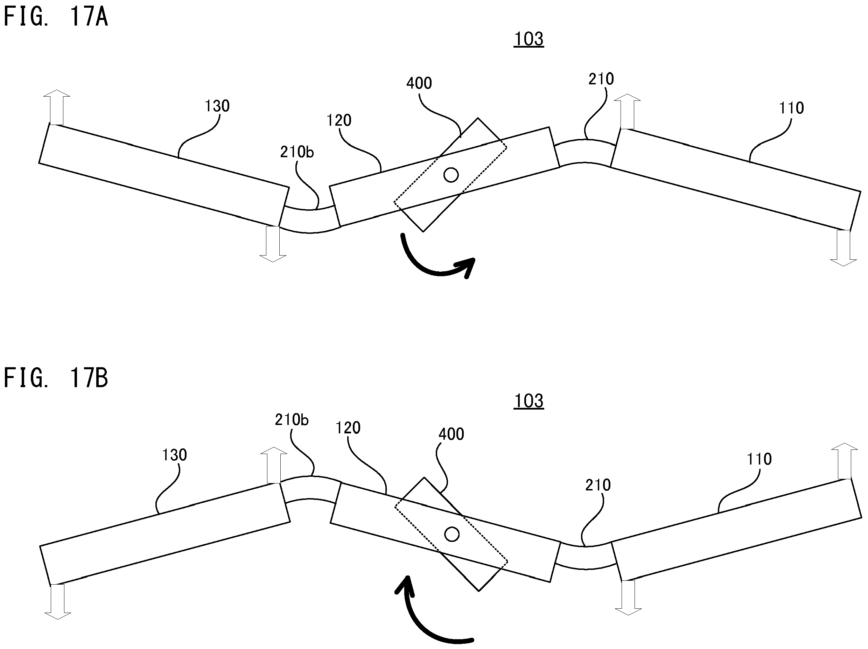

Next, with reference to FIG. 17A and FIG. 17B, the operation of the MEMS scanner 103 according to the third example will be explained. FIG. 17A and FIG. 17B are side views conceptually illustrating an aspect of the operation of the MEMS scanner according to the third example. In FIG. 17A and FIG. 17B, for convenience of explanation, detailed members that constitute the MEMS scanner 103 described in FIG. 16 will be simply illustrated, with them omitted as occasion demands.

As illustrated in FIG. 17A, for example, if a downward Lorentz force is generated near a right end of the first base 110, if an upward Lorentz force is generated near a left end, if a downward Lorentz force is generated near a right end of the third base 130, and if an upward Lorentz force is generated near a left end, then, each of the first base 110 and the third base 130 rotates in a clockwise direction. By this, the second base 120 and the mirror 400 rotate in a counterclockwise direction.

As illustrated in FIG. 17B, for example, if an upward Lorentz force is generated near the right end of the first base 110, if a downward Lorentz force is generated near the left end, if an upward Lorentz force is generated near the right end of the third base 130, and if a downward Lorentz force is generated near the left end, then, each of the first base 110 and the third base 130 rotates in the counterclockwise direction. By this, the second base 120 and the mirror 400 rotate in the clockwise direction.

As described above, even in the MEMS scanner 103 according to the third example, the mirror 400 can be rotated in a desired direction by generating the Lorentz force in each of the first base 110 and the third base 130. Particularly in the MEMS scanner 103 according to the third example, the Lorentz force is generated in each of the coil 300 provided for the first base 110 and the coil 300b provided for the third base 130. Thus, a higher driving force can be obtained in comparison with the MEMS scanner 110 according to the first example and the MEMS scanner 102 according to the second example.

Moreover, even in the third base 130, the magnetic flux can be effectively focused by inserting the yoke 600b in the opening, as in the first base 110. It is thus possible to increase the size of the apparatus.

The MEMS scanners 101, 102, and 103 according to the examples described above can be applied to various electronic devices, such as, for example, a head-up display, a head-mount display, a laser scanner, a laser printer, and a scanning driving apparatus. Therefore, these electronic devices are also included in the scope of the present invention.

The present invention is not limited to the aforementioned embodiments and examples, but various changes may be made, if desired, without departing from the invention defined in the appended claims.

A driving apparatus which involves such changes is also intended to be within the technical scope of the present invention.

### Description of Reference Numerals

- 10: support layer
- 20: active layer
- 30: BOX layer
- 40: metal layer
- 101, 102, 103: MEMS scanner
- 110: first base
- 120: second base
- 130: third base
- 210: spring part
- 220: wiring spring part
- 225: connection wire
- 300: coil
- 400: mirror
- 450: torsion bar
- 500: wire
- 600: yoke
- 650: lower yoke
- 660: first upper yoke
- 670: second upper yoke
- 710: first magnet
- 720: second magnet
- 730: third magnet
- 740: fourth magnet

## Claims

1. A driving apparatus (101) for a MEMS scanner comprising:
a first base part (110) with an opening as first space therein;
a second base part (120) with a second space therein, the second base part being placed outside the first base part;
a driven part (400) supported by the second base part in a rotatable manner in the second space;
a driving force applying part (300) configured to apply, to the first base part, a driving force for vibrating the first base part; and
an elastic part (210) configured to couple the first base part with the second base part and configured to transmit the vibration of the first base part to the second base part so as to rotate the driven part, wherein
the driving force applying part comprises:
a coil (300) disposed around said opening in the first base part (110);
a yoke (600) inserted in said opening of the first base part; and
a first magnet (710) and a second magnet (720) disposed on a lateral side of the yoke (600).

2. The driving apparatus (101) according to claim 1, wherein
the first base part (110) can rotate and vibrate around an axis along a first direction and an axis along a second direction, which is different from the first direction, due to the driving force applied from the driving force applying part (300), and
the driven part (400) can rotate around the axis along the first direction and the axis along the second direction, due to the vibration transmitted from the first base part to the second base part (120) via the elastic part (210).

3. The driving apparatus (101) according to claim 1 or 2, wherein
the first base part (110) has a layered structure including a first support layer (10) and a first active layer (20),
the second base part (120) has a layered structure including a second support layer (10) and a second active layer (20),
the elastic part (210) is formed including same layers (10) as the first support layer and the second support layer, and
a portion of at least one of the first base part and the second base part, which is connected to the elastic part, includes an area that at least partially does not have the first active layer (20) or the second active layer (20).

## Patentansprüche

1. Eine Antriebsvorrichtung (101) für einen MEMS-Scanner, aufweisend:
ein erstes Basisteil (110) mit einer Öffnung als erster Raum darin;
ein zweites Basisteil (120) mit einem zweiten Raum darin, wobei das zweite Basisteil außerhalb des ersten Basisteils angeordnet ist;
ein angetriebenes Teil (400), das durch das zweite Basisteil in dem zweiten Raum in drehbarer Weise gehalten wird;
ein Antriebskraft-Applizierteil (300), das konfiguriert ist zum Applizieren einer Antriebskraft an das erste Basisteil, sodass das erste Basisteil vibriert; und
ein elastisches Teil (210), das konfiguriert ist zum Verbinden des ersten Basisteils mit dem zweiten Basisteil und das konfiguriert ist zum Übertragen der Vibration des ersten Basisteils zu dem zweiten Basisteil, sodass das angetriebene Teil rotiert, wobei
das Antriebskraft-Applizierteil aufweist:
eine Spule (300), welche um die Öffnung in dem ersten Basisteil (110) herum angeordnet ist;
ein Joch (600), welches in die Öffnung des ersten Basisteils eingeführt ist; und
einen ersten Magneten (710) und einen zweiten Magneten (720), die an einer Seite des Jochs (600) angeordnet sind.

2. Die Antriebsvorrichtung (101) gemäß Anspruch 1, wobei
das erste Basisteil (110) um eine Achse entlang einer ersten Richtung und um eine Achse entlang einer zweiten Richtung, die sich von der ersten Richtung unterscheidet, rotieren und vibrieren kann, aufgrund der von dem Antriebskraft-Applizierteil (300) applizierten Antriebskraft, und
das angetriebene Teil (400) um die Achse entlang der ersten Richtung und um die Achse entlang der zweiten Richtung rotieren kann, aufgrund der über das elastische Teil (210) von dem ersten Basisteil zu dem zweiten Basisteil (120) übertragenen Vibration.

3. Die Antriebsvorrichtung (101) gemäß Anspruch 1 oder 2, wobei
das erste Basisteil (110) eine Schichtstruktur hat, die eine erste Stützschicht (10) und eine erste aktive Schicht (20) aufweist,
das zweite Basisteil (120) eine Schichtstruktur hat, die eine zweite Stützschicht (10) und eine zweite aktive Schicht (20) aufweist,
das elastische Teil (210) gebildet ist, sodass es die gleichen Schichten (10) wie die erste Stützschicht und die zweite Stützschicht aufweist, und
ein Abschnitt von zumindest einem von dem ersten Basisteil und dem zweiten Basisteil, der mit dem elastischen Teil verbunden ist, einen Bereich aufweist, der zumindest teilweise die erste aktive Schicht (20) oder die zweite aktive Schicht (20) nicht aufweist.

## Revendications

1. Appareil d'entraînement (101) pour un scanner MEMS comprenant :
une première partie de base (110) avec une ouverture en tant que premier espace à l'intérieur de cette dernière ;
une seconde partie de base (120) avec un second espace à l'intérieur de cette dernière, la seconde partie de base étant placée à l'extérieur de la première partie de base ;
une partie entraînée (400) supportée par la seconde partie de base, en rotation, dans le second espace ;
une partie d'application de force d'entraînement (300) configurée pour appliquer, sur la première partie de base, une force d'entraînement pour faire vibrer la première partie de base ; et
une partie élastique (210) configurée pour coupler la première partie de base à la seconde partie de base et configurée pour transmettre la vibration de la première partie de base à la seconde partie de base afin de faire tourner la partie entraînée, dans lequel :
la partie d'application de force d'entraînement comprend :
une bobine (300) disposée autour de ladite ouverture dans la première partie de base (110) ;
une culasse (600) insérée dans ladite ouverture de la première partie de base ; et
un premier aimant (710) et un second aimant (720) disposés sur un côté latéral de la culasse (600).

2. Appareil d'entraînement (101) selon la revendication 1, dans lequel :
la première partie de base (110) peut tourner et vibrer autour d'un axe le long d'une première direction et d'un axe le long d'une seconde direction, qui est différente de la première direction, en raison de la force d'entraînement appliquée par la partie d'application de force d'entrainement (300) ; et
la partie entraînée (400) peut tourner autour de l'axe le long de la première direction et de l'axe le long de la seconde direction, en raison de la vibration transmise de la première partie de base à la seconde partie de base (120) via la partie élastique (210).

3. Appareil d'entraînement (101) selon la revendication 1 ou 2, dans lequel :
la première partie de base (110) a une structure en couches comprenant une première couche de support (10) et une première couche active (20),
la seconde partie de base (120) a une structure en couches comprenant une seconde couche de support (10) et une seconde couche active (20),
la partie élastique (210) est formée en comprenant les mêmes couches (10) que la première couche de support et la seconde couche de support, et
une partie d'au moins l'une parmi la première partie de base et la seconde partie de base, qui est raccordée à la partie élastique, comprend une zone qui n'a pas, au moins partiellement, la première couche active (20) ni la seconde couche active (20).
